# EUROPÄISCHE PATENTSCHRIFT

(11) **EP 3 555 913 B1**
(45) Veröffentlichungstag und Bekanntmachung des Hinweises auf die Patenterteilung: **02.03.2022**
(21) Anmeldenummer: 18702154.8
(22) Anmeldetag: 19.01.2018
(51) Int. Cl.: H01L 23/373, H01L 23/40

(54) **HALBLEITERMODUL MIT BODENPLATTE MIT HOHLWÖLBUNG**
SEMICONDUCTOR MODULE WITH BASEPLATE WITH HOLLOW CHAMBER
MODULE À SEMI-CONDUCTEUR AVEC TOLÉRANCE DE CONCAVITÉ

(30) Priorität: 23.01.2017 EP 17152692
(43) Veröffentlichungstag der Anmeldung: 23.10.2019
(73) Patentinhaber: Siemens Aktiengesellschaft, 80333 München (DE)
(72) Erfinder: KÜRTEN, Bernd, 90587 Obermichelbach (DE)
(86) Internationale Anmeldenummer: PCT/EP2018/051258
(87) Internationale Veröffentlichungsnummer: WO 2018/134332

(56) Entgegenhaltungen:
- WO-A1-2011/040313
- DE-A1-102012 210 158
- DE-A1-102014 106 570
- US-A1- 2008 101 032

## Beschreibung

Die vorliegende Erfindung geht aus von einem Herstellungsverfahren für ein Halbleitermodul,
- wobei auf eine Oberseite eines aus einem elektrisch isolierenden Material bestehenden Substrats eine strukturierte Metallschicht aufgebracht wird und von der strukturierten Metallschicht mindestens ein elektronisches Bauelement kontaktiert wird,
- wobei auf eine Unterseite des Substrats eine metallische Kontaktschicht aufgebracht wird,
- wobei die Unterseite des Substrats in einem von mechanischen Spannungen freien Zustand des Substrats als plane Fläche ausgebildet ist.

Die vorliegende Erfindung geht weiterhin aus von einem Halbleitermodul,
- wobei das Halbleitermodul ein aus einem elektrisch isolierenden Material bestehendes Substrat aufweist, auf dessen Oberseite eine strukturierte Metallschicht aufgebracht ist, die mindestens ein elektronisches Bauelement kontaktiert, und auf dessen Unterseite eine metallische Kontaktschicht aufgebracht ist,
- wobei die Unterseite des Substrats in einem von mechanischen Spannungen freien Zustand des Substrats als plane Fläche ausgebildet ist.

Derartige Herstellungsverfahren und die mit derartigen Herstellungsverfahren hergestellten Halbleitermodule sind allgemein bekannt. Es kann auf die DE 10 2008 036 112 A1 bzw. die korrespondierende US 2009/0 039 498 A1 verwiesen werden.

Die Halbleitermodule können - sowohl im Stand der Technik als auch im Rahmen der vorliegenden Erfindung - insbesondere als Leistungs-Halbleitermodule ausgebildet sein und als elektronisches Bauelement einen Leistungshalbleiter wie beispielsweise einen IGBT oder ein ähnliches Bauelement umfassen, beispielsweise einen Leistungs-MOSFET. Derartige Halbleitermodule können beispielsweise bei Elektroautos zum Schalten der Energieversorgung von Fahrmotoren verwendet werden. Auch können sie als elektronisches Bauelement beispielsweise eine Leistungs-LED umfassen. Die elektronischen Bauelemente können Abmessungen von 5 mm x 5 mm und mehr aufweisen. Sie können insbesondere bei Halbleiterschaltern Nennspannungen von bis zu 2 kV schalten. Die geschalteten Nennströme können im zwei- oder sogar dreistelligen Amperebereich liegen.

Bei Halbleitermodulen muss die Verlustleistung vom Halbleiter in einen Kühlkörper geleitet werden. Der hierbei verwendete Lagenaufbau wird in der Regel durch Löt- oder Sinterprozesse hergestellt. Würde der Kühlkörper hier direkt mit integriert werden, müsste der gesamte Kühlkörper mit prozessiert werden. Um dies zu vermeiden, wird in der Regel zunächst nur das Halbleitermodul ohne den Kühlkörper hergestellt und sodann das Halbleitermodul mit dem Kühlkörper verbunden. Das Halbleitermodul, das den Leistungshalbleiter trägt, weist an seiner dem Kühlkörper zugewandten Seite entweder eine Kontaktschicht mit einer Dicke von mehreren 100 µm oder eine mit der Kontaktschicht verbundene Bodenplatte mit einer Dicke von mehreren Millimetern auf. In beiden Fällen wird der Übergang zum Kühlkörper durch eine Wärmeleitpaste hergestellt, die dem Ausgleich von Unebenheiten dient. Die Unebenheiten rühren daher, dass man das isolierende Substrat nicht über seine gesamte Fläche an den Kühlkörper andrücken kann und/oder dass es durch unterschiedliche Temperaturausdehnungen zu Verwindungen der Platten kommt. Derartige Wärmeleitpasten weisen eine erheblich schlechtere Wärmeleitfähigkeit auf als Löt- oder Sinterverbindungen. Weiterhin kommt es zu verschiedenen Alterungseffekten.

Wenn zur sogenannten Wärmespreizung eine Bodenplatte verwendet wird, verzieht sich weiterhin aufgrund der unterschiedlichen Ausdehnungskoeffizienten des aus einem isolierenden Material bestehenden Substrats einerseits und der metallischen Bodenplatte andererseits das Halbleitermodul beim Abkühlen. Dadurch weist die Bodenplatte in ihrem Zentralbereich eine Hohlwölbung auf. Um die Bodenplatte im Randbereich festzuschrauben, ist jedoch eine Durchbiegung in entgegengesetzter Richtung erforderlich. Im Stand der Technik ist es daher bekannt, die Bodenplatte vor dem Verbinden mit der Kontaktschicht so weit vorzuverbiegen, dass die Bodenplatte auch nach dem Verbinden mit der Kontaktschicht immer noch in der Mitte auf dem Kühlkörper aufliegt und der zunächst hochstehende Rand durch entsprechende Verbindungselemente - in der Regel Verschraubungen - auf den Kühlkörper gepresst wird. Hierzu muss zum einen die Bodenplatte weit über den übrigen Aufbau des Halbleitermoduls überstehen. Weiterhin ist es schwierig, die Vorverbiegung korrekt einzustellen.

Weiterhin weist der dadurch entstandene Aufbau auch weitere Nachteile auf. So ist beispielsweise die Planarität der montierten Bodenplatte in der Regel eher schlecht. Dies gilt insbesondere deshalb, weil der Randbereich nur im Bereich der Verbindungselemente angepresst wird und immer noch relativ dicke Schichten der Wärmeleitpaste erforderlich sind. Außerdem bleiben die Probleme mit den Alterungseffekten der Wärmeleitpaste bestehen. Weiterhin ergibt sich durch die Vorbiegung der Bodenplatte ein relativ dicker Spalt zwischen dem Substrat und der Bodenplatte, der durch eine entsprechend dicke Lötschicht gefüllt werden muss. Die Lötschicht weist in der Regel ebenfalls einen deutlich schlechteren Wärmeleitkoeffizienten auf als die Kontaktschicht und die Bodenplatte.

Aus der DE 10 2008 036 112 A1 ist ein Halbleitermodul bekannt, das aus einem Mehrschichtsubstrat mit mehreren Metallschichten und mehreren Keramikschichten besteht. Bei diesem Halbleitermodul ist keine Bodenplatte vorhanden. Die Schichten des Mehrschichtsubstrats werden beim Verbinden der Schichten miteinander mittels entsprechend gekrümmter Klemmbacken aneinandergepresst. In einer Ausgestaltung weist das Mehrschichtsubstrat in einem Zentralbereich eine Hohlwölbung auf. Das Mehrschichtsubstrat wird durch ein das Mehrschichtsubstrat zentral durchdringendes Verbindungselement mit dem Kühlkörper verbunden. Hierbei wird die Hohlwölbung beseitigt, so dass das Mehrschichtsubstrat flächig am Kühlkörper anliegt.

Die in der DE 10 2008 036 112 A1 beschriebene Vorgehensweise ist für die Herstellung eines Substrats mit einer Bodenplatte ungeeignet, da zum Verbiegen einer Bodenplatte aus Metall, die mehrere Millimeter stark ist, zu große Kräfte erforderlich wären. Derartige Kräfte würden zu einer Zerstörung der elektrisch wirksamen Elemente des Substrats führen, beispielsweise zu einer Ablösung der auf der Oberseite angeordneten Metallschicht vom Substrat und/oder vom Halbleitermodul oder einer Ablösung der Kontaktschicht vom Substrat. Die in der DE 10 2008 036 112 A1 beschriebene Vorgehensweise ist daher nur für Halbleitermodule ohne Bodenplatte praktikabel.

Die Bodenplatte bewirkt eine erhebliche Vergrößerung der Fläche, über welche die im elektronischen Bauelement entstehende Verlustwärme abgeführt werden kann. Ohne Bodenplatte können daher nur relativ schwache elektronische Bauelemente verwendet werden oder können die elektronischen Bauelemente nicht über ihren vollen Leistungsbereich betrieben werden.

Die verfahrenstechnische Aufgabe der vorliegenden Erfindung besteht darin, ein Herstellungsverfahren zu schaffen, mittels dessen bei einem Halbleitermodul mit Bodenplatte auf einfache Weise eine flächige Verbindung mit dem Kühlkörper bewirkt werden kann.

Die Aufgabe wird durch ein Herstellungsverfahren mit den Merkmalen des Anspruchs 1 gelöst. Vorteilhafte Ausgestaltungen des Herstellungsverfahrens sind Gegenstand der abhängigen Ansprüche 2 bis 9.

Erfindungsgemäß wird ein Herstellungsverfahren der eingangs genannten Art dadurch ausgestaltet,
- dass die Kontaktschicht über eine Zwischenschicht mit einer metallischen Bodenplatte verbunden wird,
- dass das Verbinden der Kontaktschicht mit der metallischen Bodenplatte bei einer erhöhten Temperatur erfolgt und sodann ein Abkühlen des Halbleitermoduls erfolgt,
- dass die dem Substrat zugewandte Seite der metallischen Bodenplatte und die von dem Substrat abgewandte Seite der metallischen Bodenplatte in einem von mechanischen Spannungen freien Zustand der Bodenplatte als plane Flächen ausgebildet sind,
- dass die Bodenplatte beim Abkühlen des Halbleitermoduls an ihrer von dem Substrat abgewandten Seite eine Hohlwölbung bildet und
- dass die metallische Bodenplatte über mindestens ein in einem Zentralbereich der Hohlwölbung angeordnetes Verbindungselement mit einem Kühlkörper verbunden und an den Kühlkörper angepresst wird.

Erfindungsgemäß werden das Substrat und die Bodenplatte zunächst als Elemente hergestellt, deren relevante Flächen - das heißt die einander zugewandten Seiten von Substrat und Bodenplatte sowie die mit dem Kühlkörper zu verbindende Seite der Bodenplatte - plane Flächen sind. Das Substrat und die Bodenplatte sind somit auf einfache Weise herstellbar. In diesem Zustand werden das Substrat und die Bodenplatte miteinander verbunden. Aufgrund der voneinander verschiedenen Wärmeausdehnungskoeffizienten von Substrat und Bodenplatte werden beim Abkühlen nach dem Verbinden von Substrat und Bodenplatte miteinander jedoch mechanische Spannungen in das Substrat und die Bodenplatte eingebracht. Diese mechanischen Spannungen bewirken ein Verbiegen des Halbleitermoduls. Insbesondere bewirken sie, dass die Bodenplatte nach dem Abkühlen des Halbleitermoduls an ihrer vom Substrat abgewandten Seite eine Hohlwölbung aufweist.

Im Rahmen der späteren Vervollständigung des Halbleitermoduls wird die metallische Bodenplatte über mindestens ein in einem Zentralbereich der Hohlwölbung angeordnetes Verbindungselement mit einem Kühlkörper verbunden und an den Kühlkörper angepresst. Durch diese Art der Verbindung kann insbesondere die Hohlwölbung beseitigt werden.

Es ist möglich, dass das Verbinden der Kontaktschicht mit der metallischen Bodenplatte und das Kontaktieren des elektronischen Bauelements mit der strukturierten Metallschicht zeitlich versetzt erfolgen. Vorzugsweise erfolgt das Verbinden der Kontaktschicht mit der metallischen Bodenplatte jedoch gleichzeitig mit dem Kontaktieren des elektronischen Bauelements mit der strukturierten Metallschicht. Dies hat fertigungstechnische Vorteile und verbessert darüber hinaus die Zuverlässigkeit des Halbleitermoduls im späteren Betrieb.

Aufgrund des Umstands, dass die einander zugewandten Seiten der Bodenplatte und des Substrats zum Zeitpunkt des Verbindens miteinander vollständig plan sind, kann die Dicke der Zwischenschicht - in der Regel eine Lötschicht oder eine Sinterschicht - sehr gering sein. Konkret kann die Zwischenschicht eine Dicke unterhalb von 100 µm aufweisen, insbesondere eine Dicke von maximal 50 µm, beispielsweise von maximal 20 µm.

Es ist möglich, das Verbindungselement "von oben" durch eine Ausnehmung im Halbleitermodul zu führen und im Kühlkörper zu befestigen. Vorzugsweise jedoch wird das Verbindungselement durch eine Ausnehmung im Kühlkörper geführt und in der Bodenplatte befestigt.

Die Bodenplatte besteht in vielen Fällen aus einem relativ weichen Material, beispielsweise Kupfer. Zur Stabilität der Befestigung wird daher vorzugsweise in die Bodenplatte ein mit dem Verbindungselement zusammenwirkendes Halteelement eingelassen, das aus einem härteren Material besteht als die Bodenplatte. Bei dem härteren Material kann es sich beispielsweise um eine Stahl oder Messing handeln. Bei dem Halteelement kann es sich beispielsweise um eine Hülse handeln.

Vorzugsweise wird in die Bodenplatte und/oder den Kühlkörper an ihren einander zugewandten Flächen im Bereich des Verbindungselements eine Vertiefung eingebracht. Dadurch kann insbesondere erreicht werden, dass der direkt miteinander in Kontakt gebrachte Bereich von Bodenplatte und Kühlkörper maximiert wird.

Ein Abstand zwischen der Bodenplatte und dem Kühlkörper kann sehr gering sein, oftmals nur wenige Mikrometer. Es ist daher in vielen Fällen nicht erforderlich, zwischen die Bodenplatte und den Kühlkörper eine Wärmeleitpaste einzubringen. Vielmehr reicht es in vielen Fällen aus, zwischen die Bodenplatte und den Kühlkörper ein von Festkörpern freies Öl oder ein Gas einzubringen. Diese Stoffe weisen insbesondere den Vorteil auf, dass sie keinen Alterungserscheinungen unterliegen.

Zur Optimierung der Hohlwölbung sollten die Dicke der Bodenplatte und die Dicke des Substrats aufeinander abgestimmt sein. Konkret können die Dicke der Bodenplatte und die Dicke des Substrats derart aufeinander abgestimmt werden, dass die Dicke der Bodenplatte mindestens fünfmal so groß ist wie die Dicke des Substrats, insbesondere mindestens zehnmal so groß.

Die Aufgabe wird weiterhin durch ein Halbleitermodul mit den Merkmalen des Anspruchs 10 gelöst. Vorteilhafte Ausgestaltungen des Halbleitermoduls sind Gegenstand der abhängigen Ansprüche 11 bis 17.

Erfindungsgemäß wird ein Halbleitermodul der eingangs genannten Art dadurch ausgestaltet,
- dass die metallische Kontaktschicht über eine Zwischenschicht mit einer metallischen Bodenplatte verbunden ist,
- dass die dem Substrat zugewandte Seite der metallischen Bodenplatte und die von dem Substrat abgewandte Seite der metallischen Bodenplatte in einem von mechanischen Spannungen freien Zustand der Bodenplatte als plane Flächen ausgebildet sind,
- dass die Bodenplatte bei Raumtemperatur des Halbleitermoduls an ihrer von dem Substrat abgewandten Seite eine Hohlwölbung aufweist und
- dass die metallische Bodenplatte über mindestens ein in einem Zentralbereich der Hohlwölbung angeordnetes Verbindungselement mit einem Kühlkörper verbunden und an den Kühlkörper angepresst ist.

Die vorteilhaften Ausgestaltungen des Halbleitermoduls korrespondieren im Wesentlichen mit den obenstehend erläuterten vorteilhaften Ausgestaltungen des Herstellungsverfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen Querschnitt durch ein Halbleitermodul in einem Zwischenstadium der Herstellung,
- FIG 2: einen Querschnitt durch das Halbleitermodul von FIG 1 in einem Endstadium der Herstellung,
- FIG 3: einen Querschnitt durch das Halbleitermodul von FIG 2 nach vollständiger Herstellung,
- FIG 4: einen Querschnitt durch das Halbleitermodul von FIG 3 nach dem Montieren eines Kühlkörpers und
- FIG 5: eine mögliche Modifikation des Halbleitermoduls von FIG 4.

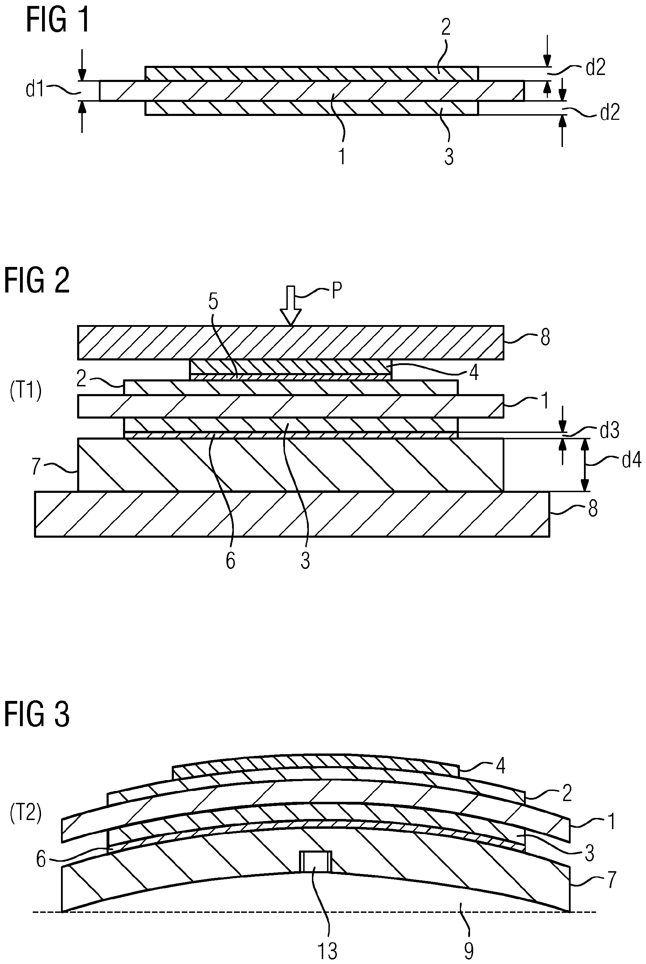

Zum Herstellen eines Halbleitermoduls wird gemäß FIG 1 zunächst auf eine Oberseite eines aus einem elektrisch isolierenden Material bestehenden Substrats 1 eine strukturierte Metallschicht 2 aufgebracht. Die strukturierte Metallschicht 2 besteht meist aus Kupfer. Alternativ kann sie aus Aluminium bestehen. Weiterhin wird auf die Unterseite des Substrats ein eine metallische Kontaktschicht 3 aufgebracht. Die metallische Kontaktschicht 3 kann ebenfalls aus Kupfer oder aus Aluminium bestehen. Meist besteht sie aus demselben Material wie die strukturierte Metallschicht 2. Das Aufbringen der metallischen Kontaktschicht 3 kann gleichzeitig oder zeitlich versetzt zum Aufbringen der strukturierten Metallschicht 2 erfolgen.

Das Substrat 1 kann zum Beispiel aus Al203 (Aluminiumoxid), AlN (Aluminiumnitrid) oder Si3N4 (Siliziumnitrid) bestehen. Das Substrat 1 einschließlich der strukturierten Metallschicht 2 und der Kontaktschicht 3 ist vorzugsweise als sogenanntes DBC-Substrat (Direct Bonded Copper), als DAB-Substrat (Direct Aluminium Bonding) oder als AMB-Substrat (Active Metal Brazing) ausgebildet. Das Substrat 1 ist in der Regel als planes Element ausgebildet. Zumindest die Unterseite des Substrats 1 ist somit in einem von mechanischen Spannungen freien Zustand des Substrats 1 eine plane Fläche. Das Substrat 1 als solches (d.h. ohne die Schichten 2, 3) weist eine Dicke d1 auf. Die Dicke d1 liegt in der Regel zwischen 0,38 mm und 1,00 mm. Die Schichten 2, 3 weisen meist eine Dicke d2 auf, die im Bereich von ca. 0,3 mm liegt.

In einem späteren Herstellungsschritt wird gemäß FIG 2 auf die strukturierte Metallschicht 2 ein elektronisches Bauelement 4 aufgebracht, das von der strukturierten Metallschicht 2 kontaktiert wird. Die Kontaktierung erfolgt in der Regel über eine dünne Zwischenschicht 5, meist eine Löt- oder Sinterschicht. Weiterhin wird, wie ebenfalls in FIG 2 dargestellt, die metallische Kontaktschicht 3 über eine weitere dünne Zwischenschicht 6 mit einer metallischen Bodenplatte 7 verbunden. Auch die weitere Zwischenschicht 6 ist in der Regel eine Löt- oder Sinterschicht. Die metallische Bodenplatte 7 besteht in der Regel aus demselben Material wie die metallische Kontaktschicht 3. Die metallische Bodenplatte 7 ist ebenfalls ein planes Element. Insbesondere sind die dem Substrat 1 zugewandte Seite der metallischen Bodenplatte 7 und die von dem Substrat 1 abgewandte Seite der metallischen Bodenplatte 7 in einem von mechanischen Spannungen freien Zustand der Bodenplatte 7 als plane Flächen ausgebildet. Vorzugsweise erfolgt entsprechend der Darstellung in FIG 2 das Verbinden der Kontaktschicht 3 mit der metallischen Bodenplatte 7 gleichzeitig mit dem Kontaktieren des elektronischen Bauelements 4 mit der strukturierten Metallschicht 2.

Aufgrund des erfindungsgemäßen Herstellungsverfahrens - insbesondere aufgrund des Umstands, dass über die Zwischenschicht 6 nur plane Flächen miteinander verbunden werden müssen - kann die Zwischenschicht 6 sehr dünn sein. Insbesondere kann die Zwischenschicht 6 eine Dicke d3 unterhalb von 100 µm aufweisen. Die Dicke d3 kann insbesondere im Bereich von maximal 50 µm liegen, beispielsweise im Bereich von maximal 20 µm. In Einzelfällen kann die Dicke d3 sogar noch darunter liegen, beispielsweise bei etwa 10 µm. Die Verbindung über eine dünne Zwischenschicht 6 ist insofern von Vorteil, weil die Zwischenschicht 6 in der Regel einen erheblich höheren thermischen Widerstand aufweist als die metallische Kontaktschicht 3 und die Bodenplatte 7.

Die Bodenplatte 7 weist eine Dicke d4 auf. Die Dicke d4 liegt in der Regel im Bereich von mehreren Millimetern, beispielsweise bei 3 mm bis 10 mm. Sie kann beispielsweise mindestens fünfmal so groß wie die Dicke d1 des Substrats 1 sein, insbesondere mindestens zehnmal so groß.

Zum Verbinden der Kontaktschicht 3 mit der metallischen Bodenplatte 7 und zum Verbinden des elektronischen Bauelements 5 mit der strukturierten Metallschicht 2 kann über Pressbacken 8 ein Druck p auf das Substrat 1 (einschließlich der sonstigen Elemente 2 bis 7) ausgeübt werden. Üblich ist dies insbesondere bei einem Sintervorgang. Insbesondere bei einem Lötvorgang kann die Ausübung des Druckes p jedoch entfallen. Weiterhin wird das Substrat 1 (einschließlich der sonstigen Elemente) auf eine erhöhte Temperatur T1 gebracht, insbesondere eine Temperatur oberhalb der später beabsichtigten Betriebstemperatur des Substrats 1, meist oberhalb von 100°C. In diesem Zustand erfolgt das Herstellen der entsprechenden Verbindungen. Die hierbei gebildeten Zwischenschichten 5, 6 - insbesondere die Zwischenschicht 6 - können dennoch sehr dünn sein, weil in diesem Zustand das Substrat 1 und die Bodenplatte 7 plan sind. Sodann erfolgt ein Abkühlen des Halbleitermoduls auf eine niedrigere Temperatur T2, beispielsweise auf Raumtemperatur, d.h. ca. 20°C.

Das Substrat 1 und die Bodenplatte 7 weisen voneinander verschiedene thermische Ausdehnungskoeffizienten auf. Insbesondere ist der thermische Ausdehnungskoeffizient des Substrats 1 in der Regel kleiner als der thermische Ausdehnungskoeffizient der Bodenplatte 7. Beim Abkühlen schrumpft die Bodenplatte 7 daher stärker als das Substrat 1. Dadurch bilden sich - ähnlich einem Bimetalleffekt - in dem das Substrat 1 und die Bodenplatte 7 umfassenden Halbleitermodul mechanische Spannungen aus. Diese Spannungen führen dazu, dass die Bodenplatte 7 beim Abkühlen des Halbleitermoduls an ihrer von dem Substrat 1 abgewandten Seite eine Hohlwölbung 9 bildet und diese Hohlwölbung 9 im abgekühlten Zustand aufweist. Dieser Zustand ist - wenn auch in übertriebener Form - in FIG 3 dargestellt.

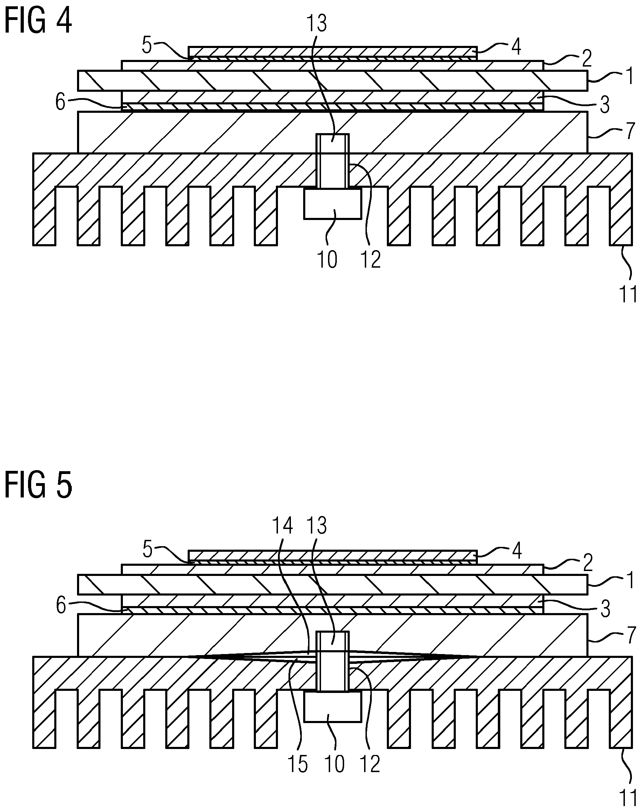

Die metallische Bodenplatte 7 wird sodann entsprechend der Darstellung in FIG 4 über mindestens ein Verbindungselement 10 mit einem Kühlkörper 11 verbunden und an den Kühlkörper 11 angepresst. Das Verbindungselement 10 ist entsprechend der Darstellung in FIG 4 in einem Zentralbereich der Hohlwölbung 9 angeordnet. Es werden also durch das Verbindungselement 10 nicht die äußeren Bereiche der Bodenplatte 7 nach unten auf den Kühlkörper 11 zu gebogen, sondern der Zentralbereich der Hohlwölbung 9. Vorzugsweise wird zu diesem Zweck das Verbindungselement 10 durch eine Ausnehmung 12 im Kühlkörper 11 geführt und in der Bodenplatte 7 befestigt.

Das Verbindungselement 10 kann beispielsweise als Schraube ausgebildet sein, die in ein entsprechendes Gewinde in der Bodenplatte 7 eingeschraubt wird. Insbesondere wenn die Bodenplatte 7 aus Kupfer besteht, ist die Bodenplatte 7 jedoch ziemlich weich. Vorzugsweise wird daher entsprechend der Darstellung in den FIG 3 und 4 in die Bodenplatte 7 ein Halteelement 13 eingelassen, das mit dem Verbindungselement 10 zusammenwirkt. Das Halteelement 13 besteht in diesem Fall aus einem härteren Material als die Bodenplatte 7. Beispielsweise kann das Halteelement 13 aus Aluminium, Messing oder Stahl bestehen. Das Halteelement 13 kann insbesondere als Hülse ausgebildet sein, die ein Innengewinde aufweist.

In einer besonders bevorzugten Ausgestaltung wird entsprechend der Darstellung in FIG 5 in die Bodenplatte 7 an ihrer dem Kühlkörper 11 zugewandten Fläche im Bereich des Verbindungselements 10 eine Vertiefung 14 eingebracht. Alternativ oder zusätzlich kann in den Kühlkörper 11 an seiner der Bodenplatte 7 zugewandten Fläche im Bereich des Verbindungselements 10 eine Vertiefung 15 eingebracht werden. Durch diese Ausgestaltung kann insbesondere erreicht werden, dass das Verbindungselement 10 einen Großteil der einander zugewandten Flächen der Bodenplatte 7 und des Kühlkörpers 11 miteinander in Kontakt bringt.

Ein Abstand zwischen der Bodenplatte 7 und dem Kühlkörper 11 kann sehr klein sein. Er kann im einstelligen Mikrometerbereich liegen. Insbesondere aus diesem Grund ist es nicht erforderlich, zwischen die Bodenplatte 7 und den Kühlkörper 11 eine Wärmeleitpaste oder dergleichen einzubringen. Stattdessen ist es ausreichend, zwischen die Bodenplatte 7 und den Kühlkörper 11 ein von Festkörpern freies Öl einzubringen oder aber zwischen die Bodenplatte 7 und den Kühlkörper 11 kein eigenes Medium einzubringen, so dass sich dort nur einige wenige Gasmoleküle befinden.

Zusammengefasst betrifft die vorliegende Erfindung somit folgenden Sachverhalt:
Auf eine Oberseite eines aus einem elektrisch isolierenden Material bestehenden Substrats 1 wird eine strukturierte Metallschicht 2 aufgebracht, von der mindestens ein elektronisches Bauelement 4 kontaktiert wird. Auf eine Unterseite des Substrats 1 wird eine metallische Kontaktschicht 3 aufgebracht. Die Unterseite des Substrats 1 ist in einem von mechanischen Spannungen freien Zustand des Substrats 1 als plane Fläche ausgebildet. Die Kontaktschicht 3 wird über eine Zwischenschicht 6 mit einer metallischen Bodenplatte 7 verbunden 7. Das Verbinden der Kontaktschicht 3 mit der metallischen Bodenplatte 7 erfolgt bei einer erhöhten Temperatur T1. Sodann erfolgt ein Abkühlen des Halbleitermoduls. Die dem Substrat 1 zugewandte Seite der metallischen Bodenplatte 7 und die von dem Substrat 1 abgewandte Seite der metallischen Bodenplatte 7 sind in einem von mechanischen Spannungen freien Zustand der Bodenplatte 7 als plane Flächen ausgebildet. Beim Abkühlen des Halbleitermoduls bildet die Bodenplatte 7 an ihrer von dem Substrat 1 abgewandten Seite eine Hohlwölbung 9.

Die vorliegende Erfindung weist viele Vorteile auf. Aufgrund der Verwendung der Bodenplatte 7 ergibt sich eine gute Wärmeabfuhr vom elektronischen Bauelement 4 zum Kühlkörper 11. Aufgrund der Planheit der miteinander zu verbindenden Flächen von Substrat 1 und Bodenplatte 7 während des Herstellungsprozesses des Halbleitermoduls ergibt sich eine minimale Dicke d3 der Zwischenschicht 6. Dies gilt sogar dann, wenn die Herstellung des Halbleitermoduls drucklos erfolgt. Der Spalt zwischen Bodenplatte 7 und dem Kühlkörper 11 ist ebenfalls sehr gering. Aufgrund des Umstands, dass auf dem Substrat 1 üblicherweise mehrere elektronische Bauelemente 4 angeordnet werden, bleibt in der Regel der Zentralbereich frei von elektronischen Bauelementen 4. Die durch das Verbindungselement 10 und gegebenenfalls das Halteelement 13 geringfügig reduzierte Wärmeleitung in diesem Bereich ist daher ohne weiteres tolerierbar. Aufgrund der Befestigung des Verbindungselements 10 in der Bodenplatte 7 (und nicht im Kühlkörper 11) ergibt sich eine Art der Befestigung, bei der nur in geringem Umfang auf die Anordnung der elektronischen Bauelemente 4 Rücksicht genommen werden muss. Aufgrund der thermischen Ausdehnungskoeffizienten des Substrats 1 und der Bodenplatte 7 verkleinert sich die Hohlwölbung 9 mit steigender Temperatur, d.h. im Betrieb. Die Verkleinerung der Hohlwölbung 9 verbessert und optimiert die Wärmeabfuhr aus den elektronischen Bauelementen 4.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Herstellungsverfahren für ein Halbleitermodul,
- wobei auf eine Oberseite eines aus einem elektrisch isolierenden Material bestehenden Substrats (1) eine strukturierte Metallschicht (2) aufgebracht wird und von der strukturierten Metallschicht (2) mindestens ein elektronisches Bauelement (4) kontaktiert wird,
- wobei auf eine Unterseite des Substrats (1) eine metallische Kontaktschicht (3) aufgebracht wird,
- wobei die Unterseite des Substrats (1) in einem von mechanischen Spannungen freien Zustand des Substrats (1) als plane Fläche ausgebildet ist,
- wobei die Kontaktschicht (3) über eine Zwischenschicht (6) mit einer metallischen Bodenplatte verbunden (7) wird,
- wobei das Verbinden der Kontaktschicht (3) mit der metallischen Bodenplatte (7) bei einer erhöhten Temperatur (T1) erfolgt und sodann ein Abkühlen des Halbleitermoduls erfolgt,
- wobei die dem Substrat (1) zugewandte Seite der metallischen Bodenplatte (7) und die von dem Substrat (1) abgewandte Seite der metallischen Bodenplatte (7) in einem von mechanischen Spannungen freien Zustand der Bodenplatte (7) als plane Flächen ausgebildet sind und
- wobei die Bodenplatte (7) beim Abkühlen des Halbleitermoduls an ihrer von dem Substrat (1) abgewandten Seite eine Hohlwölbung (9) bildet,
**dadurch gekennzeichnet, dass** die metallische Bodenplatte (7) über mindestens ein in einem Zentralbereich der Hohlwölbung (9) angeordnetes Verbindungselement (10) mit einem Kühlkörper (L) verbunden und an den Kühlkörper (11) angepresst wird.

2. Herstellungsverfahren nach Anspruch 1,
**dadurch gekennzeichnet, dass** das Verbinden der Kontaktschicht (3) mit der metallischen Bodenplatte (7) gleichzeitig mit dem Kontaktieren des elektronischen Bauelements (4) mit der strukturierten Metallschicht (2) erfolgt.

3. Herstellungsverfahren nach Anspruch 1 oder 2,
**dadurch gekennzeichnet, dass** das Verbinden der Kontaktschicht (3) und der metallischen Bodenplatte (7) über eine als Lötschicht oder als Sinterschicht ausgebildete Zwischenschicht (6) erfolgt.

4. Herstellungsverfahren nach Anspruch 1, 2 oder 3,
**dadurch gekennzeichnet, dass** die Zwischenschicht (6) eine Dicke (d3) unterhalb von 100 µm aufweist, insbesondere eine Dicke (d3) von maximal 50 µm, beispielsweise von maximal 20 µm.

5. Herstellungsverfahren nach einem der obigen Ansprüche, **dadurch gekennzeichnet, dass** das Verbindungselement (10) durch eine Ausnehmung (12) im Kühlkörper (11) geführt wird und in der Bodenplatte (7) befestigt wird.

6. Herstellungsverfahren nach einem der obigen Ansprüche, **dadurch gekennzeichnet, dass** in die Bodenplatte (7) ein mit dem Verbindungselement (10) zusammenwirkendes Halteelement (13) eingelassen wird, das aus einem härteren Material besteht als die Bodenplatte (7).

7. Herstellungsverfahren nach einem der obigen Ansprüche, **dadurch gekennzeichnet, dass** in die Bodenplatte (7) und/oder den Kühlkörper (11) an ihren einander zugewandten Flächen im Bereich des Verbindungselements (10) eine Vertiefung (14, 15) eingebracht wird.

8. Herstellungsverfahren nach einem der obigen Ansprüche, **dadurch gekennzeichnet, dass** zwischen die Bodenplatte (7) und den Kühlkörper (11) ein von Festkörpern freies Öl oder ein Gas eingebracht werden.

9. Herstellungsverfahren nach einem der obigen Ansprüche, **dadurch gekennzeichnet, dass** die Dicke (d4) der Bodenplatte (7) und die Dicke (d1) des Substrats (1) derart aufeinander abgestimmt werden, dass die Dicke (d4) der Bodenplatte mindestens fünfmal so groß ist wie die Dicke (d1) des Substrats (1), insbesondere mindestens zehnmal so groß.

10. Halbleitermodul,
- wobei das Halbleitermodul ein aus einem elektrisch isolierenden Material bestehendes Substrat (1) aufweist, auf dessen Oberseite eine strukturierte Metallschicht (2) aufgebracht ist, die mindestens ein elektronisches Bauelement (4) kontaktiert, und auf dessen Unterseite eine metallische Kontaktschicht (3) aufgebracht ist,
- wobei die Unterseite des Substrats (1) in einem von mechanischen Spannungen freien Zustand des Substrats (1) als plane Fläche ausgebildet ist,
- wobei die metallische Kontaktschicht (3) über eine Zwischenschicht (6) mit einer metallischen Bodenplatte (7) verbunden ist,
- wobei die dem Substrat (1) zugewandte Seite der metallischen Bodenplatte (7) und die von dem Substrat (1) abgewandte Seite der metallischen Bodenplatte (7) in einem von mechanischen Spannungen freien Zustand der Bodenplatte (7) als plane Flächen ausgebildet sind,
- wobei die Bodenplatte (7) bei Raumtemperatur (T2) des Halbleitermoduls an ihrer von dem Substrat (1) abgewandten Seite eine Hohlwölbung (9) aufweist,
**dadurch gekennzeichnet, dass** die metallische Bodenplatte (7) über mindestens ein in einem Zentralbereich der Hohlwölbung (9) angeordnetes Verbindungselement (10) mit einem Kühlkörper (11) verbunden und an den Kühlkörper (11) angepresst ist.

11. Halbleitermodul nach Anspruch 10,
**dadurch gekennzeichnet, dass** die Zwischenschicht (6) als Lötschicht oder als Sinterschicht ausgebildet ist.

12. Halbleitermodul nach Anspruch 10 oder 11,
**dadurch gekennzeichnet, dass** die Zwischenschicht (6) eine Dicke (d3) unterhalb von 100 µm aufweist, insbesondere eine Dicke (d3) von maximal 50 µm, beispielsweise von maximal 20 µm.

13. Halbleitermodul nach einem der Ansprüche 10 bis 12, **dadurch gekennzeichnet, dass** das Verbindungselement (10) durch eine Ausnehmung (12) im Kühlkörper (11) geführt ist und in der Bodenplatte (7) befestigt ist.

14. Halbleitermodul nach einem der Ansprüche 10 bis 13, **dadurch gekennzeichnet, dass** in der Bodenplatte (7) ein mit dem Verbindungselement (10) zusammenwirkendes Halteelement (13) eingelassen ist, das aus einem härteren Material besteht als die Bodenplatte (7).

15. Halbleitermodul nach einem der Ansprüche 10 bis 14, **dadurch gekennzeichnet, dass** die Bodenplatte (7) und/oder der Kühlkörper (11) an ihren einander zugewandten Flächen im Bereich des Verbindungselements (10) eine Vertiefung (14, 15) aufweisen.

16. Halbleitermodul nach einem der Ansprüche 10 bis 15, **dadurch gekennzeichnet, dass** sich zwischen der Bodenplatte (7) und dem Kühlkörper (11) ein von Festkörpern freies Öl oder ein Gas befinden.

17. Halbleitermodul nach einem der Ansprüche 10 bis 16, **dadurch gekennzeichnet, dass** die Dicke (d4) der Bodenplatte (7) mindestens fünfmal so groß ist wie die Dicke (d1) des Substrats (1), insbesondere mindestens zehnmal so groß.

## Claims

1. Production method for a semiconductor module,
- wherein a structured metal layer (2) is applied to an upper side of a substrate (1) composed of an electrically insulating material, and at least one electronic component (4) is contacted by the structured metal layer (2),
- wherein a metallic contact layer (3) is applied to an underside of the substrate (1),
- wherein the underside of the substrate (1) is designed as a planar surface in a state of the substrate (1) which is free from mechanical stresses,
- wherein the contact layer (3) is connected to a metallic base plate (7) by an intermediate layer (6),
- wherein the contact layer (3) is connected to the metallic base plate (7) at an elevated temperature (Tl) and the semiconductor module is then cooled,
- wherein the side of the metallic base plate (7) facing the substrate (1) and the side of the metallic base plate (7) facing away from the substrate (1) are designed as planar surfaces in a state of the base plate (7) which is free from mechanical stresses, and
- wherein the base plate (7), on cooling of the semiconductor module, forms a concave curvature (9) on its side facing away from the substrate (1),
**characterised in that** the metallic base plate (7) is connected to a heat sink (L) by at least one connecting element (10) arranged in a central region of the concave curvature (9) and is pressed against the heat sink (11).

2. Production method according to claim 1,
**characterised in that** the contact layer (3) is connected to the metallic base plate (7) at the same time as the electronic component (4) contacts the structured metal layer (2).

3. Production method according to claim 1 or 2, **characterised in that** the contact layer (3) and the metallic base plate (7) are connected by an intermediate layer (6) formed as a solder layer or as a sintered layer.

4. Production method according to claim 1, 2 or 3, **characterised in that** the intermediate layer has a thickness (d3) below 100 µm, in particular a thickness (d3) of a maximum of 50 µm, for example of a maximum of 20 µm.

5. Production method according to one of the above claims, **characterised in that** the connecting element (10) is guided through a recess (12) in the heat sink (11) and is fastened in the base plate (7).

6. Production method according to one of the above claims, **characterised in that** a holding element (13) interacting with the connecting element (10) is embedded in the base plate (7), and this is composed of a harder material than the base plate (7) .

7. Production method according to one of the above claims, **characterised in that** an indentation (14, 15) is introduced into the base plate (7) and/or the heat sink (11) on their surfaces that face each other in the region of the connecting element (10).

8. Production method according to one of the above claims, **characterised in that** a solids-free oil or a gas is introduced between the base plate (7) and the heat sink (11).

9. Production method according to one of the above claims, **characterised in that** the thickness (d4) of the base plate (7) and the thickness (d1) of the substrate (1) are matched to one another in such a way that the thickness (d4) of the base plate is at least five times as large as the thickness (d1) of the substrate (1), in particular at least ten times as large.

10. Semiconductor module,
- wherein the semiconductor module has a substrate (1) composed of an electrically insulating material, to the upper side of which a structured metal layer (2) is applied, which contacts at least one electronic component (4), and a metallic contact layer (3) is applied to the underside of the component,
- wherein the underside of the substrate (1) is designed as a planar surface in a state of the substrate (1) which is free from mechanical stresses,
- wherein the metallic contact layer (3) is connected to a metallic base plate (7) by an intermediate layer (6),
- wherein the side of the metallic base plate (7) facing the substrate (1) and the side of the metallic base plate (7) facing away from the substrate (1) are designed as planar surfaces in a state of the base plate (7) which is free from mechanical stresses,
- wherein the base plate (7), at room temperature (T2) of the semiconductor module, has a concave curvature (9) on its side facing away from the substrate (1),
**characterised in that** the metallic base plate (7) is connected to a heat sink (11) by at least one connecting element (10) arranged in a central region of the concave curvature (9) and is pressed against the heat sink (11).

11. Semiconductor module according to claim 10,
**characterised in that** the intermediate layer (6) is formed as a solder layer or as a sintered layer.

12. Semiconductor module according to claim 10 or 11, **characterised in that** the intermediate layer (6) has a thickness (d3) below 100 µm, in particular a thickness (d3) of a maximum of 50 µm, for example of a maximum of 20 µm.

13. Semiconductor module according to one of claims 10 to 12, **characterised in that** the connecting element (10) is guided through a recess (12) in the heat sink (11) and is fastened in the base plate (7).

14. Semiconductor module according to one of claims 10 to 13, **characterised in that** a holding element (13) interacting with the connecting element (10) is embedded in the base plate (7) and is composed of a harder material than the base plate (7).

15. Semiconductor module according to one of claims 10 to 14, **characterised in that** the base plate (7) and/or the heat sink (11) have an indentation (14, 15) on their surfaces that face each other in the region of the connecting element (10).

16. Semiconductor module according to one of claims 10 to 15, **characterised in that** a solids-free oil or a gas is located between the base plate (7) and the heat sink (11).

17. Semiconductor module according to one of claims 10 to 16, **characterised in that** the thickness (d4) of the base plate (7) is at least five times as large as the thickness (d1) of the substrate (1), in particular at least ten times as large.

## Revendications

1. Procédé de fabrication d'un module à semi-conducteur,
- dans lequel on dépose une couche (2) métallique structurée sur une face supérieure d'un substrat (1) en un matériau isolant électriquement et on met en contact au moins un composant (4) électronique par la couche (2) métallique structurée,
- dans lequel on dépose une couche (3) métallique de contact sur la face inférieure du substrat (1),
- dans lequel on constitue en surface plane la face inférieure du substrat (1) dans un état du substrat (1) sans contrainte mécanique,
- dans lequel on relie (7) la couche (3) de contact à une plaque métallique de fond par une couche (6) intermédiaire,
- dans lequel la liaison de la couche (3) de contact à la plaque (7) métallique de fond s'effectue à une élévation de la température (T1) et il s'effectue ensuite un refroidissement du module à semi-conducteur,
- dans lequel la face, tournée vers le substrat (1), de la plaque (7) métallique de fond et la face loin du substrat (1), de la plaque (7) métallique de fond sont constituées en surfaces planes, dans un état de la plaque (7) de fond sans contrainte mécanique, et
- dans lequel la face, loin du substrat (1), de la plaque (7) de fond forme, au refroidissement du module à semi-conducteur, une courbure (9) concave,
**caractérisé en ce que** l'on relie la plaque (7) métallique de fond à un puits (11) de chaleur par au moins un élément (10) de liaison, disposé dans la partie centrale de la courbure (9) concave et on la presse sur le puits (11) de chaleur.

2. Procédé de fabrication suivant la revendication 1, **caractérisé en ce que** la liaison de la couche (3) de contact à la plaque (7) métallique de fond s'effectue en même temps que la mise en contact du composant (4) électronique avec la couche (2) métallique structurée.

3. Procédé suivant la revendication 1 ou 2,
**caractérisé en ce que** la liaison de la couche (3) de contact et de la plaque (7) métallique de fond s'effectue par une couche (6) intermédiaire constituée sous la forme d'une couche de brasage ou d'une couche de frittage.

4. Procédé suivant la revendication 1, 2 ou 3,
**caractérisé en ce que** la couche (6) intermédiaire a une épaisseur (d3) inférieure à 100 µm, notamment une épaisseur (d3) de 50 µm au maximum, par exemple de 20 µm au maximum.

5. Procédé suivant l'une des revendications précédentes, **caractérisé en ce que** l'on fait passer l'élément (10) de liaison dans un évidement (12) du puits (11) de chaleur et on le fixe dans la plaque (7) de fond.

6. Procédé suivant l'une des revendications précédentes, **caractérisé en ce que** l'on encastre dans la plaque (7) de fond un élément (13) de maintien, qui coopère avec l'élément (10) de liaison et qui est en un un matériau plus dur que la plaque (7) de fond.

7. Procédé suivant l'une des revendications précédentes, **caractérisé en ce que** l'on ménage une cavité (14, 15) dans la plaque (7) de fond et/ou dans le puits (11) de chaleur, sur leurs surfaces tournées l'une vers l'autre, dans zone de l'élément (10) de liaison.

8. Procédé suivant l'une des revendications précédentes, **caractérisé en ce que** l'on introduit de l'huile ou un gaz exempt de corps solide entre la plaque (7) de fond et le puits (11) de chaleur.

9. Procédé suivant l'une des revendications précédentes, **caractérisé en ce que** l'on accorde l'une à l'autre l'épaisseur (d4) de la plaque (7) de fond et l'épaisseur (d1) du substrat (1), de manière à ce que l'épaisseur (d4) de la plaque de fond représente au moins cinq fois l'épaisseur (d1) du substrat (1), notamment au moins dix fois.

10. Module à semi-conducteur,
- dans lequel le module à semi-conducteur a un substrat (1) en un matériau isolant électriquement, sur la face supérieure duquel est déposée une couche (2) métallique structurée, qui est en contact avec au moins un composant (4) électronique et sur la face inférieure duquel est déposée une couche (3) métallique de contact,
- dans lequel la face inférieure du substrat (1) est constituée en surface plane dans un état du substrat (1) sans contrainte mécanique,
- dans lequel la couche (3) métallique de contact est reliée à une plaque (7) métallique de fond par une couche (6) intermédiaire,
- dans lequel la face, tournée vers le substrat (1), de la plaque (7) métallique de fond et la face, loin du substrat (1), de la plaque (7) métallique de fond sont constituées en surfaces planes, dans un état de la plaque (7) de fond sans contrainte mécanique,
- dans lequel la plaque (7) de fond a, à la température (T2) ambiante du module à semi-conducteur, sur sa face loin du substrat (1), une courbure (9) concave,
**caractérisé en ce que** la plaque (7) métallique de fond est reliée à un puits (11) de chaleur par au moins un élément (10) de liaison, disposé dans une zone centrale de la courbure (9) concave, et est pressée sur le puits (11) de chaleur.

11. Module à semi-conducteur suivant la revendication 10, **caractérisé en ce que** la couche (6) intermédiaire est constituée sous la forme d'une couche de brasage ou d'une couche de frittage.

12. Module à semi-conducteur suivant la revendication 10 ou 11, **caractérisé en ce que** la couche (6) intermédiaire a une épaisseur (d3) inférieure à 100 µm, notamment une épaisseur (d3) de 50 µm au maximum, par exemple de 20 µm au maximum.

13. Module à semi-conducteur suivant l'une des revendications 10 à 12,
caractérisé en ce l'élément (10) de liaison passe dans un évidement (12) du puits (11) de chaleur et est fixé dans la plaque (7) de fond.

14. Module à semi-conducteur suivant l'une des revendications 10 à 13,
**caractérisé en ce qu'**un élément (13) de maintien, qui coopère avec l'élément (10) de liaison et qui est en un matériau plus dur que la plaque (7) de fond, est encastré dans la plaque (7) de fond.

15. Module à semi-conducteur suivant l'une des revendications 10 à 14,
**caractérisé en ce que** la plaque (7) de fond et/ou le puits (11) de chaleur ont, sur leurs surfaces tournées l'une vers l'autre, une cavité (14, 15) dans la zone de l'élément (10) de liaison.

16. Module à semi-conducteur suivant l'une des revendications 10 à 15,
**caractérisé en ce qu'**une huile ou un gaz exempt de corps solide se trouve entre la plaque (7) de fond et le puits (11) de chaleur.

17. Module à semi-conducteur suivant l'une des revendications 10 à 16,
**caractérisé en ce que** l'épaisseur (d4) de la plaque de fond représente au moins cinq fois l'épaisseur (d1) du substrat (1), notamment au moins dix fois.
